# EUROPEAN PATENT SPECIFICATION

(11) **EP 1 898 295 B1**
(45) Date of publication and mention of the grant of the patent: **18.03.2015**
(21) Application number: 07115108.8
(22) Date of filing: 28.08.2007
(51) Int. Cl.: G06F 1/16, G06F 3/041

(54) **Touch-sensitive input device and electronic device incorporating the touch-sensitive input device**
Berührungsempfindliche Eingabevorrichtung und elektronisches Gerät mit der berührungsempfindlichen Eingabevorrichtung
Dispositif d'entrée tactile et dispositif électronique incorporant le dispositif d'entrée tactile

(30) Priority: 30.08.2006 US 824006 P
(43) Date of publication of application: 12.03.2008
(73) Proprietor: HTC Corporation, Taoyuan County 330 (TW)
(72) Inventor: Huang, Hsing-Chiang, Taoyuan (TW); Huang, Che-Hung, Taoyuan (TW); Liu, Hsiu-Chin, Taoyuan (TW); Cheng, Hsun-Wen, Taoyuan (TW); Ho, Chin-Wei, Taoyuan (TW); Chang, Yao-Tsung, Taoyuan (TW)
(74) Representative: Lang, Christian

(56) References cited:
- EP-A- 1 376 449
- WO-A-98/21702
- US-A- 4 977 397
- US-A1- 2002 158 838
- US-A1- 2004 095 334
- US-A1- 2004 222 974
- US-A1- 2006 012 578
- US-A1- 2006 033 722

## Description

### CROSS-REFERENCE TO RELATED APPLICATIONS

This application claims the benefit of U.S. Provisional Application No. 60/824,006, filed August 30, 2006, which is herein incorporated by reference in its entirety.

### BACKGROUND OF THE INVENTION

The present invention relates generally to an input device and, more particularly, to a touch-sensitive input device and a portable electronic device incorporating the touch-sensitive device.

With the progress in semiconductor manufacturing processes and telecommunications techniques, interest in a compact, light-weight and low-profile input device for electronic devices such as personal digital assistants ("PDAs") and mobile phones is growing. However, conventional input devices, for embodiment, keyboards, mice, touch pads, touch screens and joysticks, are generally too large-sized relative to electronic devices, and therefore require additional spaces external to the electronic devices. To overcome the drawbacks, input devices integrable with electronic devices have been proposed. An embodiment of such an input device can be seen in U.S. Patent Application Publication No. 2003/0095096 by Robbin et al., entitled "Method and Apparatus for Use of Rotational User Inputs". Robbin discloses a method and an apparatus for transforming a rotational user action supplied by a user at a user input device into a linear action. However, it may be optically and operationally more user-friendly to have a liner user input followed by a liner output than a rotational user input followed by a linear output. Furthermore, conventional input devices may be configured to be disposed on a surface of an electronic device where a display device is located, which may not help reduce the device size and lower the utility efficiency of an outer area of the device. The European patent application EP 1376449 A2 discloses a mobile communication terminal having a touch panel overlaid to a display, wherein the touch panel is connected to a flexible printed circuit FPC which may be connected with a main board or connector.

It is thus desirable to have an input device that is able to be integrable with increasingly compact and low-profile electronic devices. It is also desirable to have an input device that allows a linear user input followed by a linear output. Furthermore, it is desirable to have an input device that provides flexibility in configuration and pattern to achieve area efficiency. linear user input followed by a linear output. Furthermore, it is desirable to have an input device that provides flexibility in configuration and pattern to achieve area efficiency.

### BRIEF SUMMARY OF THE INVENTION

The present invention provides a touch-sensitive input device for use in a portable electronic device, such as a PDA or a mobile phone, according to the appended claims.

### BRIEF DESCRIPTION OF THE SEVERAL VIEWS OF THE DRAWINGS

The foregoing summary, as well as the following detailed description of the invention, will be better understood when read in conjunction with the appended drawings. For the purpose of illustrating the invention, there are shown in the drawings embodiments consistent with the invention. It should be understood, however, that the invention is not limited to the precise arrangements and instrumentalities shown.

In the drawings:
FIGS. 1A and 1B are diagrams of an input device consistent with an embodiment of the present invention;
FIG. 1C is a schematic diagram of an input device consistent with another embodiment of the present invention;
FIG. 2A is an exploded view of an electronic device consistent with an embodiment of the present invention;
FIG. 2B is a perspective view of the electronic device illustrated in FIG. 2A when assembled;
FIG. 2C is a cross-sectional view of the electronic device illustrated in FIG. 2A when assembled;
FIG. 2D is a rear plan view of a main circuit board of the electronic device illustrated in FIG. 2A;
FIG. 3 is a schematic diagram of an electronic device consistent with another embodiment of the present invention;
FIG. 4 is a schematic diagram of an input device consistent with another embodiment of the present invention;
FIG. 5A is a schematic diagram of an electronic device consistent with another embodiment of the present invention;
FIGS. 5B and 5C are schematic diagrams of electronic devices consistent with still other embodiments of the present invention; and
FIGS. 6A and 6B are schematic diagrams of input devices consistent with still other embodiments of the present invention.

### DETAILED DESCRIPTION OF THE INVENTION

Reference will now be made in detail to the present embodiments of the invention, embodiments of which are illustrated in the accompanying drawings. Wherever possible, the same reference numbers will be used throughout the drawings to refer to the same or like portions. It should be noted that the drawings are in greatly simplified form and are not to precise scale. In reference to the disclosure herein, for purposes of convenience and clarity only, directional terms such as front, side and rear are used with respect to the accompanying drawings. Such directional terms used in conjunction with the following description of the drawings should not be construed to limit the scope of the invention in any manner not explicitly set forth in the appended claims.

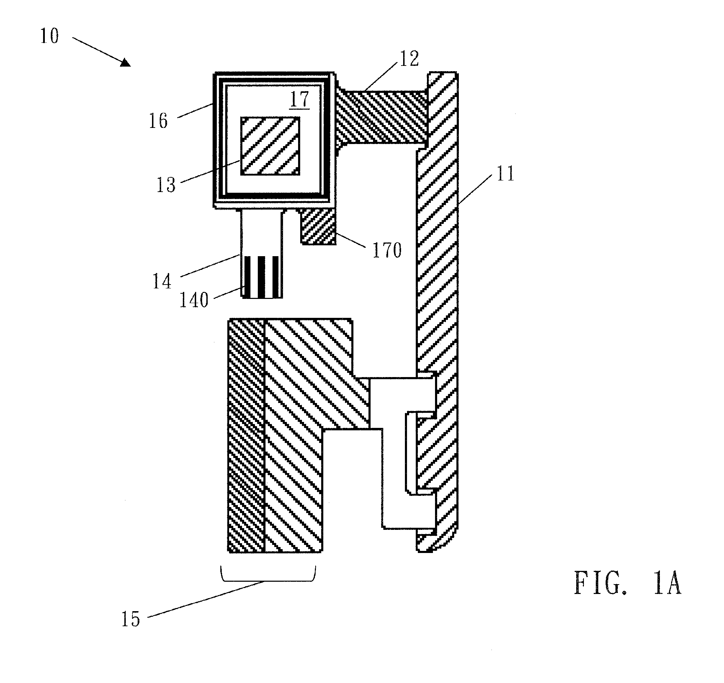

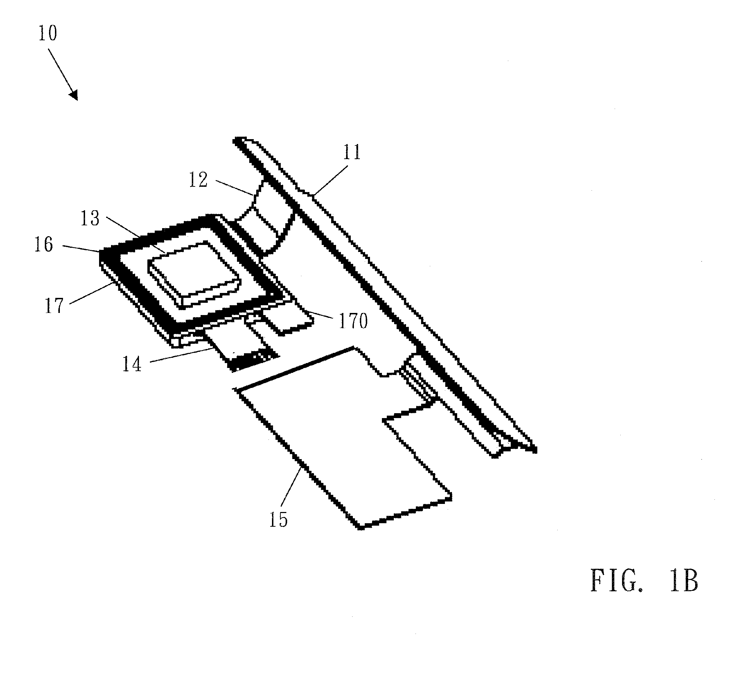

FIGs. 1A and 1B are diagrams of an input device 10 consistent with an embodiment of the present invention. Referring to FIG. 1A, the input device 10 includes a touch pad 11, a flexible printed circuit ("FPC") 12 and a processor 13. The touch pad 11, the FPC 12 and the processor 13 of the input device 10 are electrically connected and may be integrally formed in one piece. The input device 10 serves as an interface between a user and an electronic device, for embodiment, a PDA, a mobile phone or a notebook computer. The touch pad 11 refers to a touch-sensitive device capable of receiving a user input through, for embodiment, the user's finger or a stylus. Specifically, with the touch pad 11, the movement of a cursor on a display screen corresponds to the relative movements of the user's finger as the finger taps or moves along a surface of the touch pad 11. The touch pad 11 facilitates a selection on the display screen when one or more taps are detected on the surface of the touch pad 11. In one embodiment consistent with the present invention, a linear user input, i.e., a linear movement of the user's finger on the touch pad 11, is transformed to a linear or sequential output, i.e., a linear or sequential movement of a cursor or pointer on a display screen. In another embodiment, a linear user input is transformed to a circular output. In still another embodiment, a circular user input is transformed to a linear output. The touch pad 11 in one embodiment is a capacitive-type touch pad such that taps or movements of the user's finger result in changed capacitance. Signals including information of the changed capacitance are transmitted to the processor 13 through the FPC 12 and then detected by the processor 13. The processor 13, configured in the form of an integrated circuit ("IC"), is electrically connectable to a main processor on a main circuit board through a connector 14. In one embodiment, the connector 14 is configured in the form of a sheet on which conductive wires such as gold fingers 140 are formed. The connector 14 includes a male connector for connecting to a female connector disposed on a main circuit board, or vice versa.

In one embodiment consistent with the present invention, the input device 10 further includes a ground pad 15, integrally formed with the touch pad 11, for the purpose of electrically grounding. The ground pad 15 includes, for embodiment, a flexible conductive sheet. In another embodiment consistent with the present invention, the input device 10 further includes a metal shielding cover 16 to protect the processor 13 from electromagnetic interference ("EMI"). The metal shielding cover 16 is electrically connected to a ground layer 170 of a substrate 17 that supports the processor 13. In one embodiment, one of the gold fingers 140 of the connector 14 is electrically connected to the ground layer 170.

Referring to FIG. 1B, in operation, the FPC 12 may be flexibly bent to allow the touch pad 11 and the processor 13 to be positioned at different orientations or different surfaces of an electronic device (not shown). Thus the positions of the touch pad 11 and the processor 13 are non-coplanar, which facilitates the utility efficiency of the outer area of the electronic device. Furthermore, the ground pad 15 may be flexibly bent to also allow the touch pad 11 and the ground pad 15 to be positioned at different orientations or different surfaces of an electronic device. Thus the positions of the touch pad 11 and the ground pad 15 are non-coplanar.

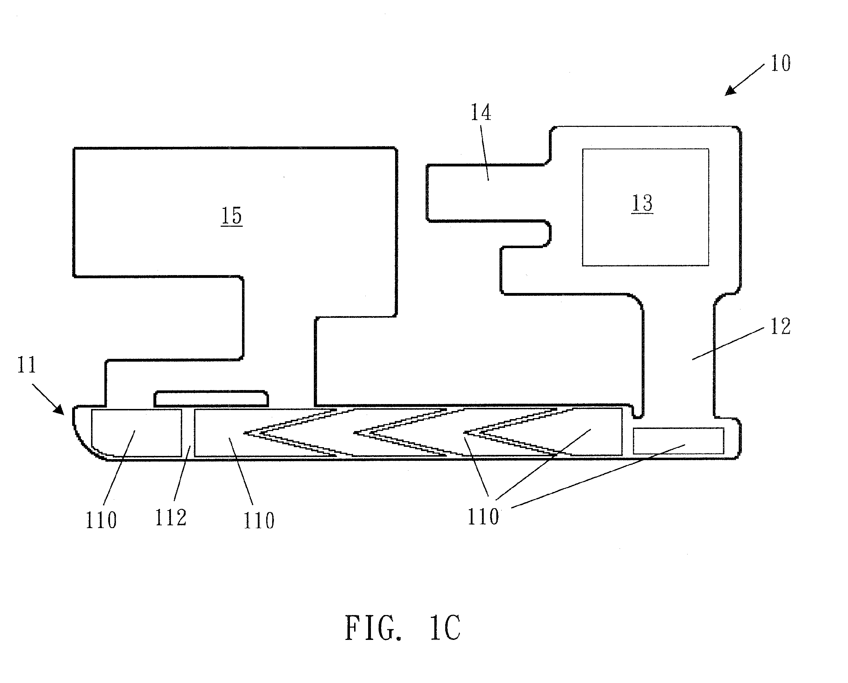

FIG. 1C is a schematic diagram of an input device 10 consistent with an embodiment of the present invention. Referring to FIG. 1C, the input device 10 includes the touch pad 11 further including a plurality of touch-sensitive areas 110 separated from each other and surrounded by a non-touch-sensitive area 112.

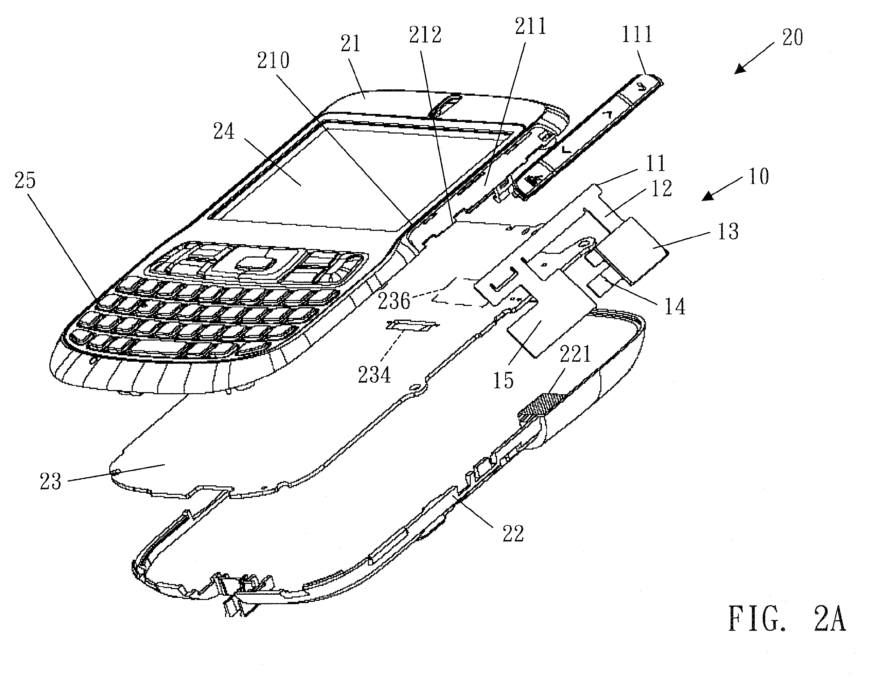

FIG. 2A is an exploded view of an electronic device 20 consistent with an embodiment of the present invention. Referring to FIG. 2A, the electronic device 20, for embodiment, a PDA or a mobile phone, includes a housing further comprising a front cover 21 and a back cover 22, a main circuit board 23 disposed within the housing, a display device 24 disposed in an opening of the front cover 21, a keypad 25 disposed on the front cover 21 and an input device 10. The input device 10 includes a touch pad 11, an FPC 12, a processor 13, a connector 14 and a flexible ground pad 15. When assembled, the touch pad 11 is located on a surface in a recess region 211 in an inclined sidewall 210 of the front cover 21. A cover 111, for embodiment, a plastic sheet, is configured with the housing to protect the touch pad 11 from physical damage, contamination or moisture attack. Skilled persons in the art will understand that the touch pad 11 may be disposed on the sidewall 210 without any recess region or protection by the cover 111. The FPC 12 and the flexible ground pad 15 extend through a slot 212 adjacent to the recess region 211 into an inner space defined by the front cover 21 and the back cover 22. The slot 212 is formed as the front cover 21 and the back cover 22 are assembled. The connector 14 is electrically coupled to a connector 234 disposed on the main circuit board 23. The main circuit board 23 further includes a ground area 236 to facilitate grounding.

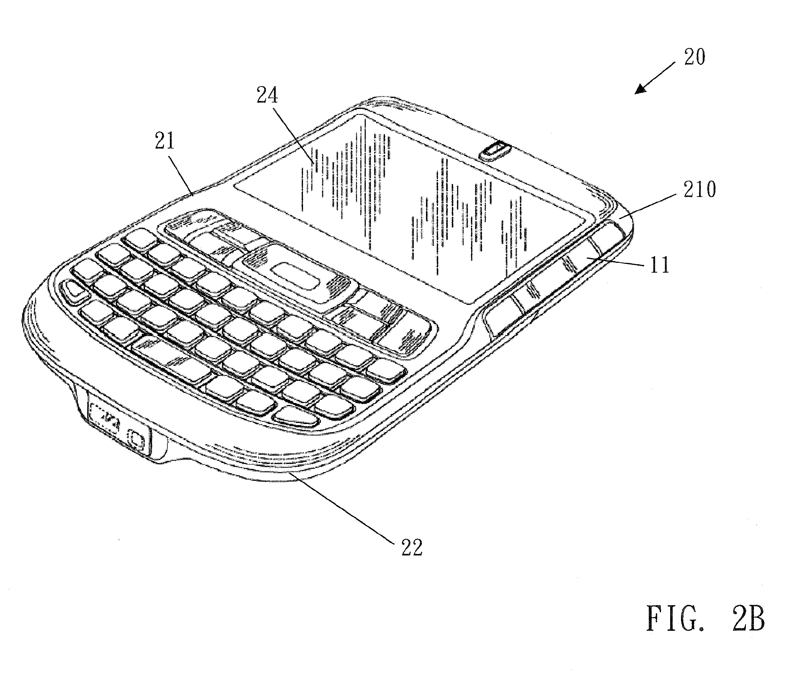

FIG. 2B is a perspective view of the electronic device 20 illustrated in FIG. 2A when assembled. Referring to FIG. 2B, the touch pad 11 is disposed on the inclined sidewall 210 near the display 24. The inclined sidewall 210 includes an inclined surface with respect to the display 24.

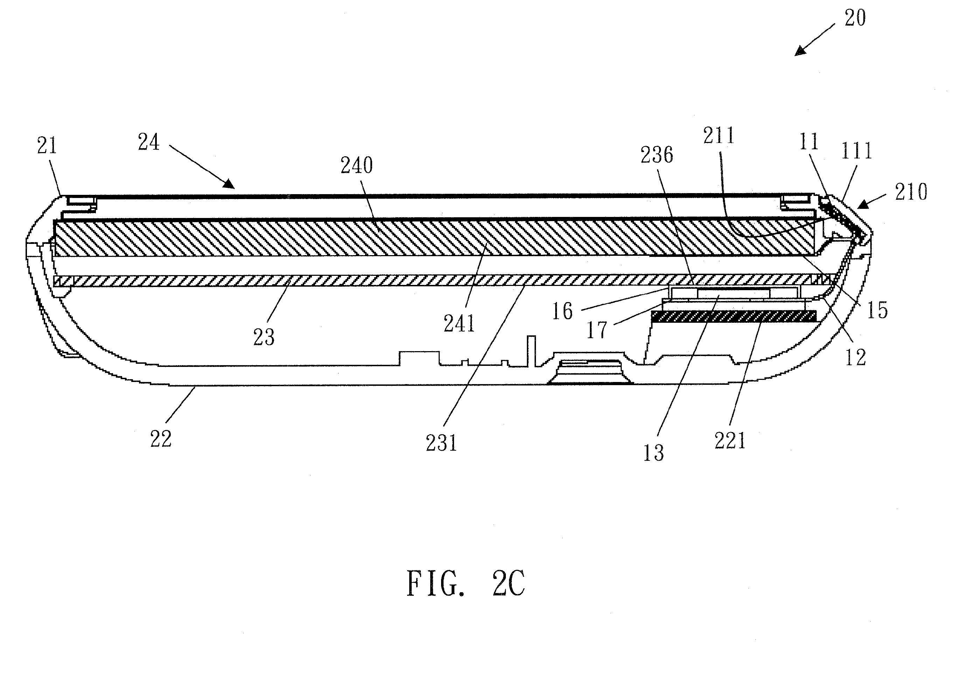

FIG. 2C is a cross-sectional view of the electronic device 20 illustrated in FIG. 2A when assembled. Referring to FIG. 2C, the touch pad 11 is disposed on a surface in the recess region 211 of the inclined sidewall 210. The ground pad 15 is electrically connected to a display module casing 240 which receives an LCD display 24. Specifically, a portion of the ground pad 15 is electrically connected to a surface 241 of the conductive display module casing 240 for grounding. The FPC 12 bent into the inner space extends across the main circuit board 23 to electrically connect the processor 13 positioned on a back surface 231 of the main circuit board 23, wherein the surface in the recess region 211 and the back surface 231 of the main circuit board 23 are non-coplanar. The processor 13 is held on a substrate 17 and enclosed by a metal shielding cover 16. In the present embodiment, a resilient biasing member 221 (also referring to FIG. 2A) such as a sponge immobile relative to the back cover 22 abuts against the substrate 17 to allow the processor 13 positioned on the back surface 231 of the main circuit board 23, and allow the metal shielding cover 16 to contact the ground area 236 formed on the back surface 231.

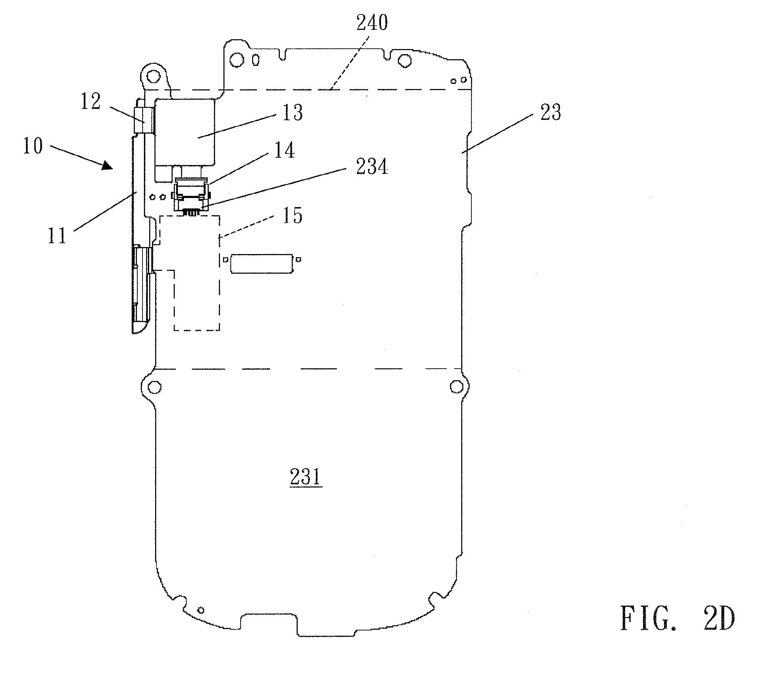

FIG. 2D is a rear plan view of the main circuit board 23 of the electronic device 20 illustrated in FIG. 2A. Referring to FIG. 2D, the connector 14 of the input device 10 is electrically coupled to the connector 234 disposed on the back surface 231 of the main circuit board 23. Both of the display module casing 240 and the ground pad 15, illustrated in dotted lines, are disposed above the front surface (not numbered) of the main circuit board 23. Also referring to FIG. 2C, the touch pad 11, the ground pad 15 and a package (not numbered) including the processor 13, the substrate 17 and the metal shielding cover 16 are disposed on different surfaces of the electronic device 20, and those surfaces are non-coplanar.

Skilled persons in the art understand that an "antenna effect" may occur to an electronic device if an input device of the electronic device includes only one grounded end. For embodiment of an input device of an electronic device including a touch pad, a processor and a flexible printed circuit (FPC) electrically connecting the touch pad and the processor, if the FPC is grounded with a main circuit board only by a ground layer or by one of gold fingers of a connector formed on the FPC and when the electronic device such as a mobile phone emanates a radio frequency (RF) signal, the RF signal may cause noise signals in the touch pad and the noise signals may in turn disturb the cursor action on a display because the input device has only one grounded end. Such a phenomenon is called the "antenna effect".

To prevent an electronic device from the antenna effect, in an embodiment consistent with the present invention, referring to FIG. 1A, an input device 10 of an electronic device (not shown) includes a touch pad 11, a processor 13 and a flexible printed circuit (FPC) 12 electrically connecting the touch pad 11 and the processor 13, a ground layer 170 or a connector 14 electrically connected to the FPC 12 for grounding purpose, and a ground pad 15 extending from one end of the touch pad 11 for grounding. As a result, the input device 10 includes two grounded ends. The antenna effect that may otherwise occur in the electronic device due to interaction between the RF signal and the input device may be greatly alleviated.

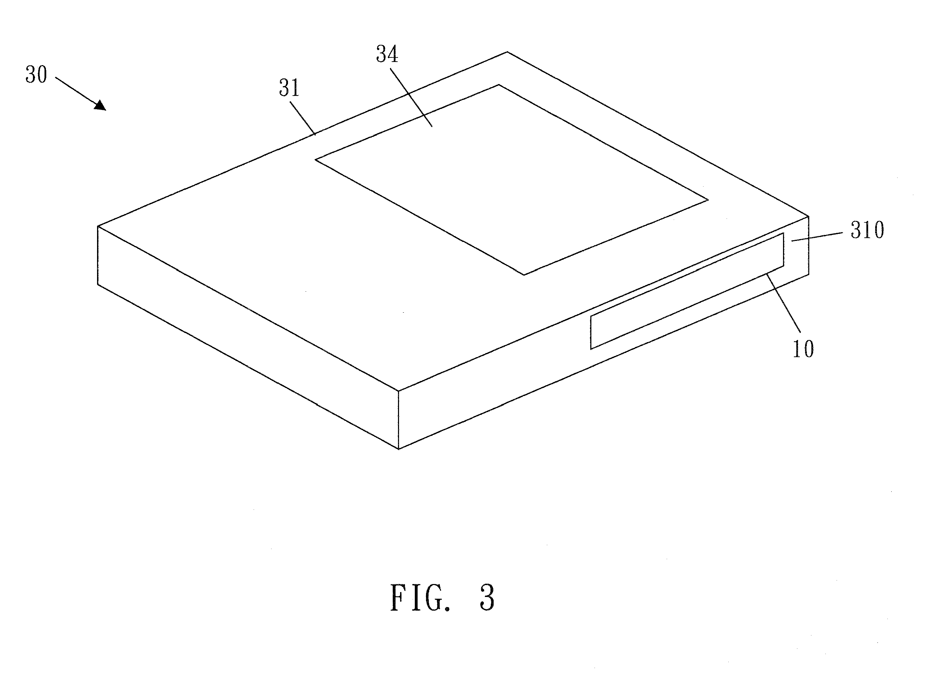

FIG. 3 is a schematic diagram of an electronic device 30 consistent with another embodiment of the present invention. Referring to FIG. 3, the electronic device 30 is similar in structure to the electronic device 20 illustrated in FIG. 2B except a vertical sidewall 310 instead of the inclined sidewall 210. In this embodiment, the input device 10 is also located on the sidewall 310 of the electronic device 30, which is vertical with respect to the display 34 disposed on the front cover 31.

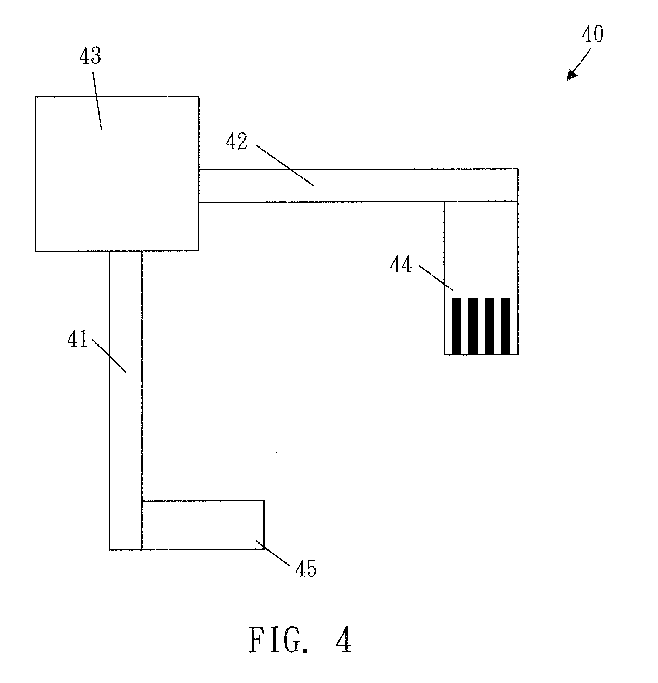

FIG. 4 is a schematic diagram of an input device 40 consistent with another embodiment of the present invention. Referring to FIG. 4, the input device 40 used in an electronic device (not shown) includes a touch pad 41, a processor 43 directly connected to one end of the touch pad 41, and one end of an FPC 42 connected to the processor 43, wherein the touch pad 41 is used to be positioned on a sidewall of the electronic device. The input device 40 further includes a connector 44 extending from the other end of the FPC 42 and a ground pad 45 extending from the other end of the touch pad 41. As previously discussed, the connector 44 formed on the other end of the FPC 42 is electrically connectable to an electric contact including an connector formed on a surface or a position on a main circuit board (not shown) of the electronic device, and the ground pad 45 is electrically connectable to a conductive module casing (not shown), for example. Thus two ends of the FPC 42 are positioned on different surfaces which are non-coplanar.

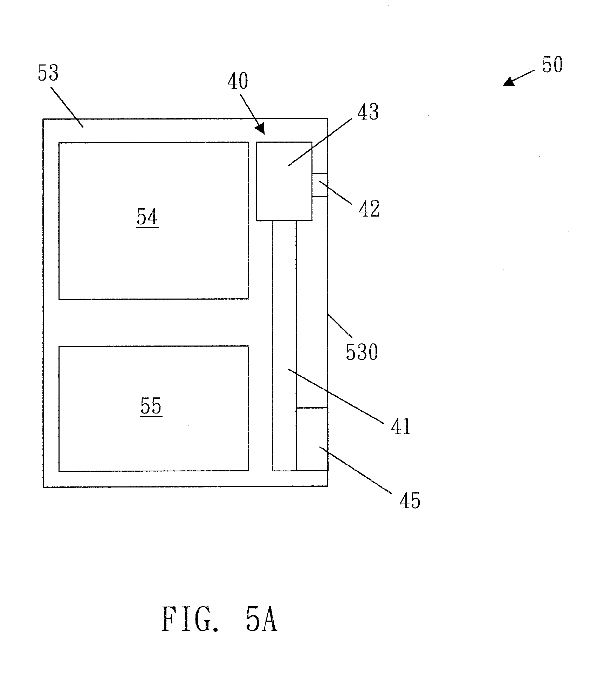

FIG. 5A is a schematic diagram of an electronic device 50 consistent with another embodiment of the present invention. Referring to FIG. 5A, the electronic device 50 includes a main circuit board 53, a display 54, a keypad 55 and the input device 40 as illustrated in FIG. 4, in which the housing of the electronic device 50 is omitted for clearer illustration. The display 54 and the keypad are both disposed over the main circuit board 53. The touch pad 41 and the processor 43 are both disposed over the main circuit board 53, wherein the processor 43 is used to be hidden inside the housing of the electronic device 50 and the touch pad 41 is used to be exposed and disposed on a sidewall of the housing of the electronic device 50. The other end of FPC 42 extends across a side 530 of the main circuit board 53 to electrically connect an electric contact including a connector (not shown) formed on the rear surface of the main circuit board 53, and the ground pad 45 is bent to electrically connect, for example, a ground area (not shown) formed on the main circuit board 53.

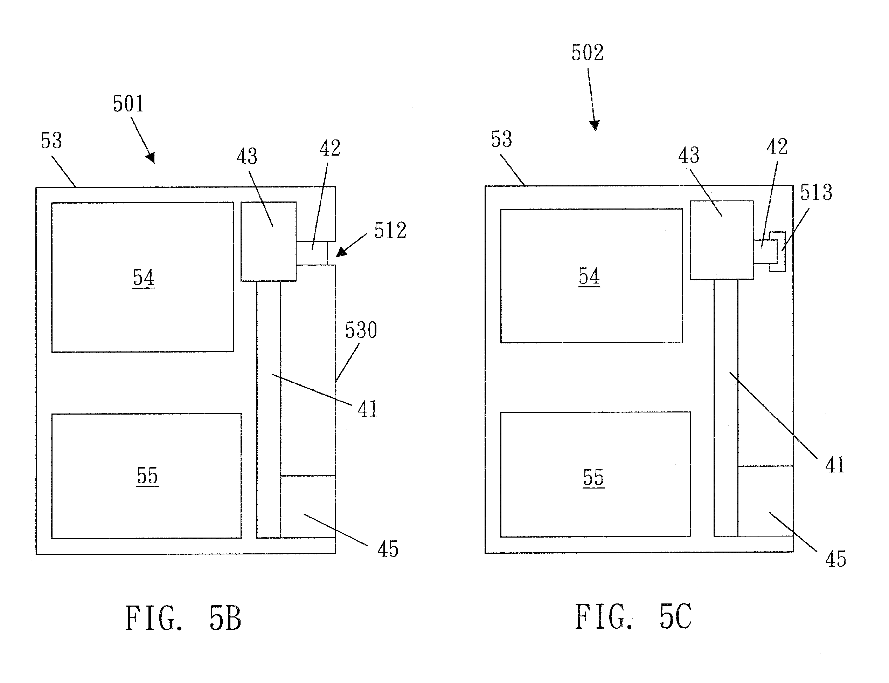

FIGS. 5B and 5C are schematic diagrams of electronic devices 501 and 502 consistent with still other embodiments of the present invention. Referring to FIG. 5B, the electronic device 501 is similar in structure to the electronic device 50 illustrated in FIG. 5A except that an notch 512 is formed at the side 530 of the main circuit board 53, which facilitates extension of the FPC 42 across the main circuit board 53. Referring to FIG. 5C, the electronic device 502 is similar in structure to the electronic device 50 illustrated in FIG. 5A except that an opening 513 is formed through the main circuit board to facilitate extension of the FPC 42 across the main circuit board 53. In the embodiments illustrated in FIGS. 5A, 5B and 5C, they reveal that different surfaces on which two ends of the FPC 42 are positioned are non-coplanar.

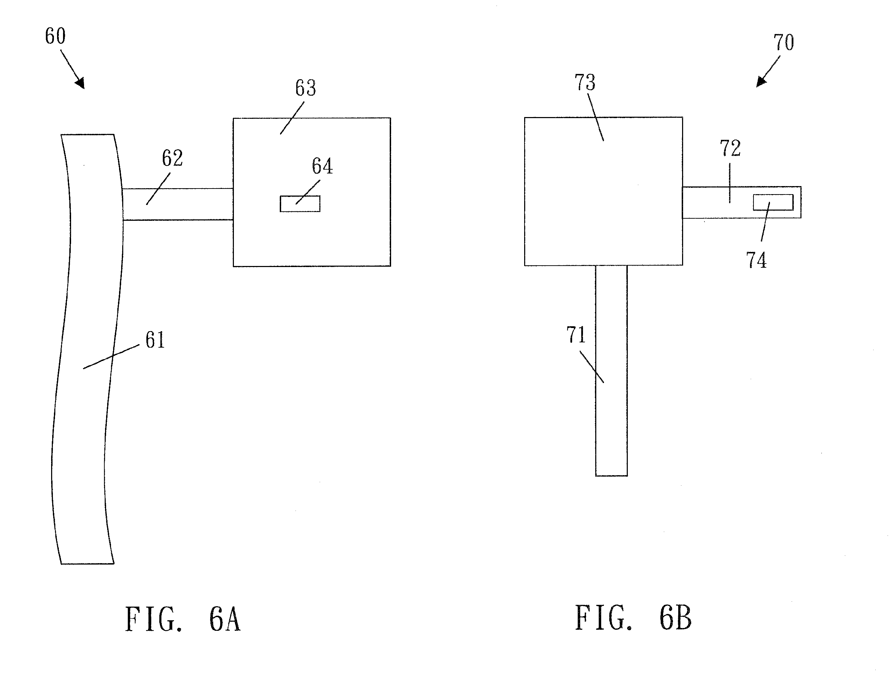

FIGS. 6A and 6B are schematic diagrams of input devices 60 and 70 used in electronic devices (not shown) consistent with still other embodiments of the present invention. Referring to FIG. 6A, the input device 60 includes a touch pad 61, a processor 63, an FPC 62 connecting the touch pad 61 and the processor 63, and a connector 64 connected to the processor 63, wherein the touch pad 61 is used to be positioned on a sidewall of the electronic device. The touch pad 61 includes a streamlined shape and the connector 64 is integrated with the processor 63. Referring to FIG. 6B, the input device 70 includes a touch pad 71 with a rectangular shape, a processor 73 connected to the touch pad 71, an FPC 72 connected to the processor 73, and a connector 74 integrated with the FPC 72.

It will be appreciated by those skilled in the art that changes could be made to one or more of the embodiments described above without departing from the broad inventive concept thereof. It is understood, therefore, that this invention is not limited to the particular embodiments disclosed, but it is intended to cover modifications within the scope of the present invention as defined by the appended claims.

## Claims

1. An electronic device, comprising:
a touch pad (11) disposed on a first surface, capable of outputting a signal when touched;
a processor (13) disposed on a second surface, capable of processing the signal,
a connector (14) electrically connected to the processor, wherein the connector comprises a plurality of gold fingers, and one of the gold fingers is used for grounding;
a ground pad (15) electrically connected to the touch pad (11), wherein the ground pad (15) is flexibly bent to allow the touch pad (11) and the ground pad (15) to be positioned at different orientations and different surfaces of the electronic device; and
a flexible printed circuit (12) electrically connecting the touch pad (11) on the first surface and the processor (13) on the second surface, wherein the second surface and the first surface are non-coplanar.

2. The electronic device of claim 1, further comprising a housing, wherein the touch pad (11) is disposed on a sidewall of the housing, and the sidewall includes an inclined sidewall or a vertical sidewall.

3. The electronic device of claim 1, further comprising a main circuit board with a ground area formed thereon, wherein the processor (13) includes an integrated circuit and a shielding cover enclosing the integrated circuit and the shielding cover electrically contacts the ground area.

4. The electronic device of claim 3, wherein a notch or an opening is formed at a side of the main circuit board for the flexible printed circuit (12) extending through.

## Patentansprüche

1. Elektronisches Gerät, das umfasst:
ein Berührungsfeld (11), welches an einer ersten Fläche ausgebildet ist und in der Lage ist, bei Berührung ein Signal auszugeben;
einen Prozessor (13), welcher an einer zweiten Fläche ausgebildet ist und in der Lage ist, das Signal zu verarbeiten;
einen Anschluss (14), welcher elektrisch mit dem Prozessor verbunden ist, wobei der Anschluss eine Vielzahl von Goldfingeranschlüssen umfasst, und wobei einer der Goldfingeranschlüsse für die Erdung verwendet wird;
ein Erdungsfeld (15), welches elektrisch mit dem Berührungsfeld (11) verbunden ist, wobei das Erdungsfeld (15) flexibel gebogen ist, um zu ermöglichen, dass das Berührungsfeld (11) und das Erdungsfeld (15) in verschiedenen Orientierungen und an verschiedenen Flächen des elektronischen Gerätes positioniert werden können; und
einen flexibel gedruckten Schaltkreis (12), welcher elektrisch mit dem Berührungsfeld (11) auf der ersten Fläche und dem Prozessor (13) auf der zweiten Fläche verbunden ist, wobei die zweite Fläche und die erste Fläche nicht komplanar sind.

2. Elektronisches Gerät nach Anspruch 1, das weiter ein Gehäuse umfasst, wobei das Berührungsfeld (11) an einer Seitenwand des Gehäuses ausgebildet ist und die Seitenwand eine geneigte Seitenwand oder eine vertikale Seitenwand ist.

3. Elektronisches Gerät nach Anspruch 1, das weiter eine Hauptleiterplatte mit einem darauf ausgebildeten Erdungsbereich umfasst, wobei der Prozessor (13) einen integrierten Schaltkreis und einen den integrierten Schaltkreis abdeckenden Abschirmdeckel aufweist, wobei der Abschirmdeckel elektrisch den Erdungsbereich kontaktiert.

4. Elektronisches Gerät nach Anspruch 3, wobei eine Aussparung oder eine Öffnung an einer Seite der Hauptleiterplatte ausgebildet ist, damit der flexibel gedruckte Schaltkreis (12) sich durch diese hindurch erstreckt.

## Revendications

1. Dispositif électronique comprenant :
un pavé tactile (11) disposé sur une première surface, capable de sortir un signal lorsqu'il est touché ;
un processeur (13) disposé sur une seconde surface, capable de traiter le signal ;
un connecteur (14) relié électriquement au processeur, le connecteur comprenant une pluralité de doigts dorés et l'un des doigts dorés étant utilisé pour la mise à la terre ;
un pavé de terre (15) relié électriquement au pavé tactile (11), le pavé de terre (15) étant courbé de manière flexible pour permettre au pavé tactile (11) et au pavé de terre (15) d'être positionnés dans différentes orientations et sur différentes surfaces du dispositif électronique et
un circuit imprimé flexible (12) qui relie électriquement le pavé tactile (11) sur la première surface et le processeur (13) sur la seconde surface, la seconde surface et la première surface n'étant pas coplanaires.

2. Dispositif électronique selon la revendication 1 comprenant de plus un boîtier, le pavé tactile (11) étant disposé sur une paroi latérale du boîtier et la paroi latérale comprenant une paroi latérale inclinée ou une paroi latérale verticale.

3. Dispositif électronique selon la revendication 1 comprenant de plus une plaquette de circuit principal avec une zone de terre formée dessus, le processeur (13) comprenant un circuit intégré et un recouvrement de blindage qui enferme le circuit intégré et le recouvrement de blindage établit le contact électrique avec la zone de terre.

4. Dispositif électronique selon la revendication 3, une encoche ou une ouverture étant formée sur un côté de la plaquette de circuit principal pour que le circuit imprimé flexible (12) passe à travers.
